**Europäisches Patentamt**

**European Patent Office**

**Office européen des brevets**

(11) Publication number: **0 237 361**
**B1**

(12) **EUROPEAN PATENT SPECIFICATION**

(45) Date of publication of patent specification: **30.01.91**

(21) Application number: **87302183.6**

(22) Date of filing: **13.03.87**

(51) Int. Cl.⁵: **H 01 L 27/10**, G 11 C 11/40

(54) Semiconductor memory device.

(30) Priority: **13.03.86 JP 56120/86**

(43) Date of publication of application:
**16.09.87 Bulletin 87/38**

(45) Publication of the grant of the patent:
**30.01.91 Bulletin 91/05**

(84) Designated Contracting States:
**DE FR GB**

(56) References cited:
**EP-A-0 169 346**
**EP-A-0 234 741**

**INTERNATIONAL ELECTRON DEVICES
MEETING, Washington, DC, 1st-4th December
1985, pages 694-697, IEEE, Washington, DC, US;
H. SUNAMI: "Cell structures for future DRAM's"
1985 IEEE INTERNATIONAL SOLID-STATE
CIRCUITS CONFERENCE DIGEST OF
TECHNICAL PAPERS, Coral Gables, February
1985, 32nd ISSCC, pages 244-255,355, Coral
Gables, FL, US; F. HORIGUCHI et al.: "A 1Mb
DRAM with a folded capacitor cell structure"**

(73) Proprietor: **MITSUBISHI DENKI KABUSHIKI
KAISHA
2-3, Marunouchi 2-chome Chiyoda-ku
Tokyo 100 (JP)**

(72) Inventor: **Furutani, Kiyohiro
C/O Mitsubishi Denki K.K. LSI Kenkyusho
1, Mizuhara 4-chome, Itami-shi Hyogo-ken (JP)**
Inventor: **Mashiko, Koichiro
C/O Mitsubishi Denki K.K. LSI Kenkyusho
1, Mizuhara 4-chome, Itami-shi Hyogo-ken (JP)**
Inventor: **Arimoto, Kazutami
C/O Mitsubishi Denki K.K. LSI Kenkyusho
1, Mizuhara 4-chome, Itami-shi Hyogo-ken (JP)**

(74) Representative: **Barnard, Eric Edward et al
BROOKES & MARTIN High Holborn House 52/54
High Holborn
London WC1V 6SE (GB)**

Courier Press, Leamington Spa, England.

## Description

### Field of the Invention

The present invention relates to a semiconductor memory device and particularly to a device with memory cells configured for a high level of integration.

### Background to the Invention

A semiconductor memory device of the type with which the present invention is concerned was proposed in lecture number FAM 17.4 of the IEEE International Solid State Conference (ISSCC) 1985 and is described in more detail hereinafter. Although this type of device decreases the planar areas needed for the creation of the data charge storage capacitance of the memory cells the configuration still imposes a limitation on the degree of integration.

A general object of the present invention is to provide an improved semiconductor memory device and memory cell configuration.

### Summary of the Invention

According to the invention, there is provided a semiconductor memory device composed of an array of memory cells arranged in rows and columns to form a matrix, each memory cell comprising a data charge storage capacitor and a transfer gate, the transfer gate being in the form of a transistor on the substrate with source and drain regions, a channel, isolation oxide films on both sides of the channel, word lines extending parallel to one another in a first direction to pass over the channels of the transistors, bit lines connected to the source/drain regions of the transistors, the bit lines extending parallel to one another and in a second direction orthogonal to the first direction with every two adjacent bit lines forming a folded bit line pair; wherein adjacent memory cells are arranged in pairs with the cells of each pair sharing a common contact for connection with a respective bit line, the memory cells being arranged in lines parallel to the word lines, with the transistor of first memory cells of the respective memory cell pairs in a memory cell pair line having its channel positioned under one of the word lines so as to be controlled thereby and the transistors of a second memory cell pairs in the same memory cell pair line having its channel positioned under another word line adjacent to said one word line, to be controlled thereby and wherein the adjacent memory cell pair lines and the memory cell pairs adjacent to each other in the same memory cell pair line are separated by trenches with an isolation layer at the bottom of each trench, so that each pair of memory cells is surrounded by an isolation trench, the data charge storage capacitors of the memory cells being at least partly formed by capacitors on the sidewalls of the trenches surrounding the pairs of memory cells.

Preferably, the memory cells are elongated in the direction of the word lines while the overall surface area is unchanged. As a result, a margin or a space is created which can be used for forming an isolation oxide film between the transfer gates of the memory cells and the periphery of the memory cells.

A device constructed in accordance with the invention can be at a high level of integration yet is free of the need to provide an isolation trench particularly close to the channel regions of the transfer gates. Consequentially the leakage currents are minimized and the transistors can be reliably turned OFF.

Even where isolation trenches are formed throughout the entirety of the periphery of each memory cell and the data charge storage capacitors are formed practically throughout the entire trench sidewalls, the leakage currents can still be maintained at the level found in normal LOCOS (local oxidization of silicon).

### Brief Description of the Drawings

The invention may be understood more readily, and various other features of the invention may become apparent from consideration of the following description, in conjunction with the accompanying drawings, wherein:-

Fig. 1A is a plan view of part of a conventional semiconductor memory device;

Fig. 1B is a cross-section along the line 1b-1b of Fig. 1A;

Fig. 2 is a sectional plan view taken along the line II-II of Fig. 1A on a somewhat larger scale;

Fig. 3 is a plan view showing a part of a semiconductor memory device constructed in accordance with the invention;

Fig. 4 is a circuit diagram depicting how the memory cells of the device of Fig. 3 are connected;

Fig. 5 is a sectional view taken along the line V-V of Fig. 3; and

Fig. 6 is a perspective representation of part of the device of the invention composed of two memory cells with a common contact hole.

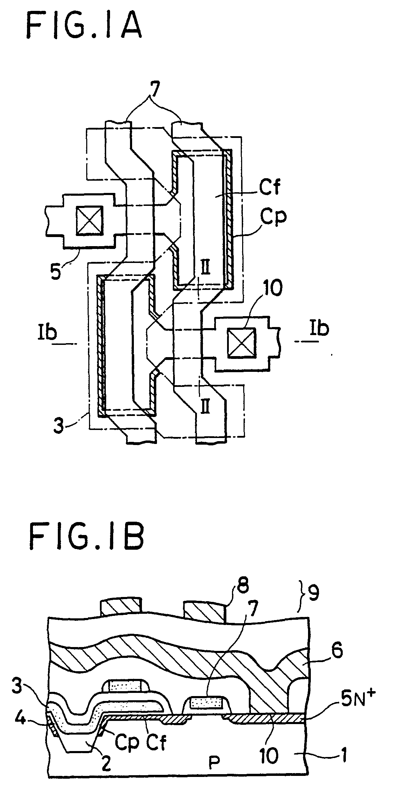

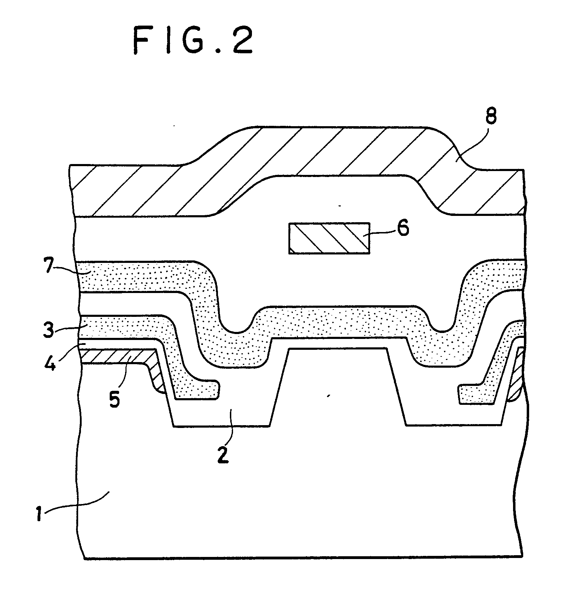

An example of a highly intergrated dynamic semiconductor memory device of the type proposed in the lecture number FAM 17.4 of ISSCC 1985 is shown in Figs. 1A, 1B and 2. As illustrated, the device comprises a p-type semiconductor substrate 1, a field oxide film 2 at the base of an isolation trench in the substrate, a first poly-silicon layer 3 overlying the film 2, a capacitor insulating film 4, and an $n^+$ diffusion layer 5 on the flat portion of the substrate 1. A first A1 interconnection layer 6 forms bit lines. A second poly-silicon layer 7 and a second A1 layer 8 forms word lines 9. Although not illustrated as such, the second poly-silicon layer 7 is electrically connected at regular intervals with the second A1 interconnection layer 8 to reduce the effective resistance of the word lines 9. Contact holes 10 serve for electrical connection of the first A1 interconnection layer 6 to the $n^+$ diffusion layer 5. Cp represents a data charge storage capacitor formed from the poly-silicon layer 3 and the $n^+$ diffusion layer 5 on the respective sides of the trench and isolated from one another by the capacitor insulating film 4 serving as a dielectric. Cf represents a data charge storage capacitor formed of the poly-silicon layer 3, the insulating film 4 and the n$^+$ diffusion layer 5 on the flat part of the substrate 1.

By utilizing the sidewalls of the isolation trenches to form the data charge storage capacitance Cp, the area needed for the data charge storage capacitance Cf on the flat part of the substrate 1 is reduced. As a result, any reduction in the overall chip area does not necessarily lead to a reduction in the operational characteristics and the data charge storage capacitance can be secured against minority carriers injected because of external influences e.g. radiation such as alpha particles. As the periphery of the memory cells is lengthened, the trench may be made shallower in order to maintain the same collective data charge storage capacitance Cp+Cf. A conventional highly-integrated dynamic semiconductor memory of a folded-bit line configuration (further described in Japanese Published Patent Application No 74535/1976) can use the above-described memory cells in which case the device will take the form depicted in Fig. 2. As illustrated, the layer 3 must be etched so that its edges lie at the bottom of the trenches 2. However, where the trenches are to have a minimal width, etching the layer 3 to create terminal edges at the bottom of the trenches is difficult. Moreover, there are normally isolation trenches on both sides of the channel region of the transistor transfer gate controlled by the layer 7 forming the word line. Leakage currents tend to flow through the sidewalls of the isolation trenches making it difficult to ensure the relevant transistors are turned off.

Description of Preferred Embodiment

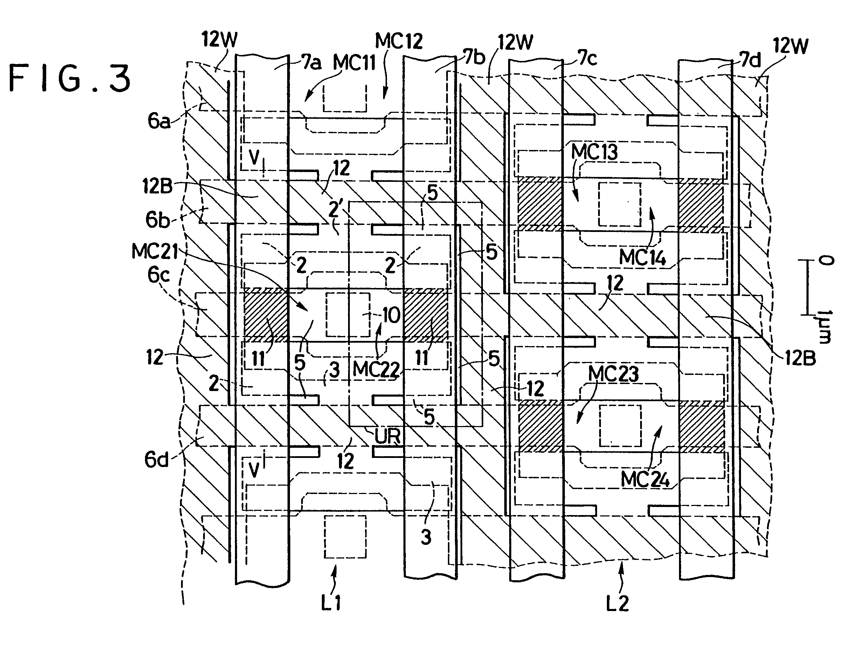

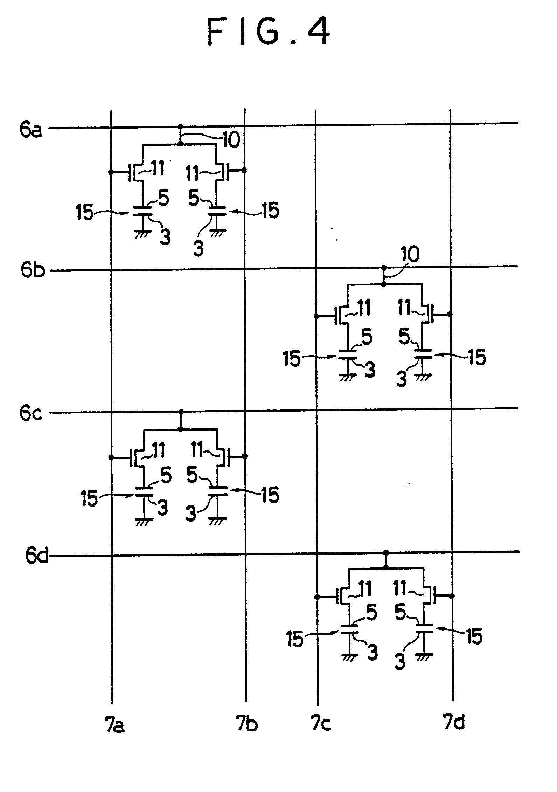

Figs. 3 to 6 depict part of a memory device constructed in accordance with the invention. As illustrated, the device comprises memory cells MC11-MC24 arranged in columns and rows to form a matrix. As with the known device, the cells are provided on a p-type substrate 1. Throughout Figs. 3 to 6: 2 denotes field oxide film used to isolate the elements, and 2' a similar oxide film on the sidewalls of the isolation trenches designated 12. 3 denotes a first poly-silicon layer which provides electrodes for data charge storage capacitors 15 which have a dielectric insulation film 4. An n$^+$ diffusion layer 5 provides the other electrodes for the capacitors 15. A first A1 interconnection layer 6 forms bit lines while a second poly-silicon layer 7 forms word lines. Contact holes 10 provide connection between the layers 6 and 5. Cp denotes the capacitor formed on the sidewalls of the trenches 12 by the layers 3, 4, 5 which form part of the data charge storage capacitors 15. Cf denotes the capacitor on the flat part of the substrate 1 formed by the layers 3, 4, 5 and also forming part of the data charge storage capacitors 15.

Each of the memory cells comprises a transistor transfer gate and a data charge storage capacitor 15 and the channels of the transistors (FETs or MOSFETs) which provide the gates are designated 11. The source and drain of the MOSFETs are provided by regions of the n$^+$ diffusion layer 5 while the gate electrodes are provided by one of the word lines 7a-7d. Beneath the isolation films 2, 2' on the flat part of the substrate 1 and the bottom sidewalls of the trenches 12 are p-type impurity-diffused layers 14, similar to that provided for ordinary LOCOS isolation.

The word lines 7a-7d extend parallel to one another in a first direction to pass over the channels 11 of the transistors. The bit lines 6a-6d also extend parallel to one another but in a second direction orthogonal to the first direction. Each of the alternate bit lines 6a and 6c and the adjacent one of the interleaving bit lines 6b and 6d, e.g., one immediately below said each of the alternate bit lines form a folded bit line pair.

Every two memory cells MC11 and MC12; MC13 and MC14; MC21 and MC22; and MC23 and MC24 adjacent to each other form a memory cell pair sharing a contact hole 10 for connection with a respective bit line 6a—6d.

The memory cell pairs are arranged in memory cell pair lines L1, L2 parallel to the word lines 7a-7d. The transistors of the first ones MC11, MC13, MC21, MC23 of the memory cells of the respective memory cell pairs in a memory cell pair line L1 or L2 have their channels 11 positioned under one of the word lines 7a, 7c so as to be controlled thereby. The transistors of second memory cells MC12, MC14, MC22, MC24 of the respective memory cell pairs in the same memory cell pair lines L1, L2 have their channels 11 positioned under another word line 7b, 7d adjacent to the word lines 7a, 7c, so as to be controlled thereby.

The memory cells MC11, MC12, MC21, MC22 of the memory cell pairs in alternate memory cell pair lines (L1 et al) are connected to alternate bit lines 6a, 6c, and the memory cells MC13, MC14, MC23, MC24 of the memory cell pairs in adjacent memory cell pair lines (L2 et al) are connected to the intervening bit lines 6b, 6d.

The memory cell pair lines L1, L2 adjacent to each other are separated by parts 12W of the isolation trenches 12 extending in the direction of the word lines. The memory cell pairs adjacent to each other in the same memory cell pair line L1, L2 are separated from each other by parts 12B of the isolation trenches 12, extending in the direction of the bit lines. As a result, each of the memory cell pairs are surrounded by isolation trench parts 12W, 12B.

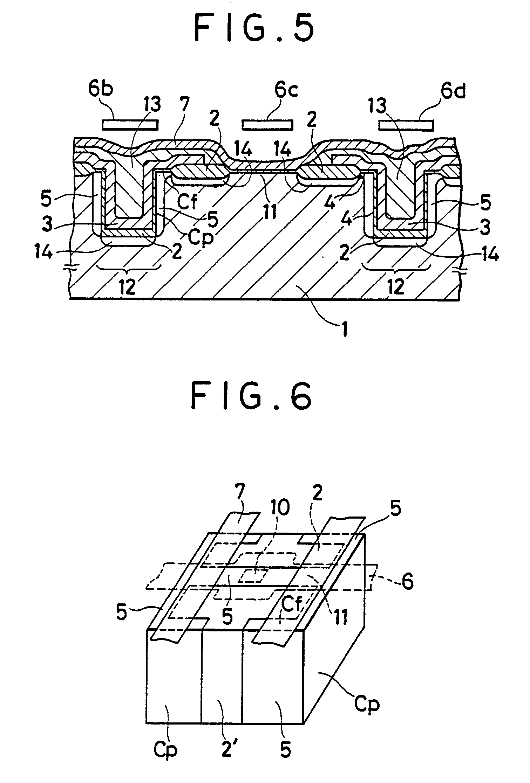

The data charge storage capacitor 15 of each memory cell is partly formed by capacitors (Cp Fig. 5) on the sidewalls of the isolation trench parts 12W, 12B surrounding the memory cell pairs. The data charge storage capacitor Cp of one of the memory cells of each memory cell pair is separated from the data charge storage capacitor Cp of the other memory cell of the memory cell pair by the isolation oxide film 2' (Fig. 6) formed on the sidewalls of the isolation trench parts 12B.

The channel 11 of the transistor of each memory cell is separated from the data charge storage capacitor 15 by the isolation oxide film 2 formed on a flat part of the substrate 1 between the channel 11 and the isolation trench part 12B. Each data charge storage capacitor Cp comprises a first electrode formed by the $n^+$ diffusion layer 5 on the sidewall of the isolation trench 12, an insulating film 4 as a dielectric formed on the $n^+$ diffusion layer 5 and a second electrode formed by the poly-silicon layer 3 on the insulating film 4.

The bit lines 6a, 6c connected to the memory cells MC11, MC12, MC21, MC22 in a memory cell pair line L1 pass over the isolation trench parts 12B separating adjacent memory cell pairs from each other in an adjacent memory cell line L2. Thus, the memory cell pairs in a memory cell pair line L1 are offset by half a pitch, i.e. the interval between successive memory cell pairs in the same line, in the direction of the word lines with respect to the memory cell pairs in another memory cell pair line L2 adjacent to the memory cell pair line L1.

As shown in Fig. 3, a region for one bit memory cell comprises one channel 11 which extend in a vertical direction from the lower half of an A1 interconnection 6b to the upper half of an A1 interconnection 6d, and, in the horizontal direction from the centre of a contact hole 10 to the centre of an isolation trench 12, as indicated by chain line UR. Two bit lines (one half of 6b, one half of 6d and an entirety of 6c) pass through the one bit memory cell region UR, and one word line (the entire width of 7b) passes through the one bit memory cell region UR. Every two bit lines (e.g., 6c and 6d) adjacent to each other are connected externally (not shown) to form a folded bit line pair as known per se. When a word line, e.g., 7a is at a high potential, the transistors with their channels 11 under the word line 7a are conductive and hence those transistors connect the respective data charge storage capacitors 15 to the respective bit lines such as 6c, while the adjacent bit lines such as 6d are disconnected from the corresponding data charge storage capacitors 15 because the corresponding transistors with their channels under the word lines such as 7c are non-conductive. In other words, when a memory cell connected to a bit line, e.g., 6c is selected, none of the memory cells connected to the other bit line of the folded bit line pair, e.g., 6d is selected.

With the structure described above, isolation trenches 12 are formed along the entire periphery of the memory cells and parts Cp of the data charge storage capacitors 15 are formed on the sidewalls of the isolation trenches. Because a flat isolation oxide film 2 is provided on both sides of each transfer gate 11, it is not necessary to pattern the first poly-silicon layer 3 to have its edge within the region of the isolation trenches as shown in Fig. 2. Therefore, the fabrication process is simplified.

Furthermore, the isolation trenches 12 and the transistor channel regions 11 are not close to each other, so that control of the leakage current from the word line 7 is minimized. As a result, the data charge retention characteristic is improved.

As shown in Fig. 6, by providing the parts Cp of the data charge storage capacitors 15 with electrodes formed through the entire sidewalls of the isolation trenches 12, except for a portion of the sidewalls used for separating the two memory cells sharing the contact hole 10 from one another where the isolation oxide film 2' is present, means that a relatively large capacitance can be obtained even if the trenches 12 are shallow.

As an example, Fig. 3 shows memory cells designed on a 0.8 micrometer basis. Where the cell area = 2.6 micrometer × 4.2. micrometer = 10.92 square micrometer, the capacitance of 50 fF ($1 fF = 10^{-15}$ F) can be obtained, if the thickness of the capacitance insulating film is 0.01 micrometer (100Å) and the depth of the isolation trenches is 1.94 micrometer. Thus, the isolation trenches can be shallower than those of the memory cells of a known 4M bit DRAM.

In the embodiment described, memory cells having a transfer gate with an n-type channel 11 formed on a p-type substrate 1 are described. However, it may be so arranged that the memory cells have a transfer gate with a p-type channel formed on an n-type substrate.

## Claims

1. A semiconductor memory device composed of an array of memory cells in a folded bit line configuration; said device comprising;

a semiconductor substrate (1);

memory cells (MC11—MC24) arranged in rows and columns to form a matrix, each memory cells comprising a data charge storage capacitor (15) and a transfer gate, the transfer gate being in the form of a transistor on the substrate with source and drain regions, a channel (11), isolation oxide films (2, 2') on both sides of the channel (11), word lines (7a—7d) extending parallel to one another in a first direction to pass over the channels (11) of the transistors, bit lines (6a—6d) connected to the source/drain regions of the transistors, the bit lines extending parallel to one another and in a second direction orthogonal to the first direction with every two adjacent bit lines forming a folded bit line pair; wherein adjacent memory cells are arranged in pairs with the cells of each pair sharing a common contact (10) for connection with a respective bit line, the memory cells being arranged in lines parallel to the word lines, with the transistors of first memory cells of the respective memory cell pairs in a memory cell pair line (L1, L2) having their channels (11) positioned under one word line 7a, 7c so as to be controlled thereby and the transistors of second memory cells of the respective memory cell pairs in the same memory cell pair line having their channels (11) positioned under another word line (7b, 7d) adjacent to said one word line, to be controlled thereby and wherein the adjacent memory cell pair lines and the memory cell pairs adjacent to each other in the same memory cell pair line are separated by trenches (12) with an isolation layer at the bottom of each trench, so that each pair of memory cells is surrounded by an isolation trench, the data charge storage capacitors (15) of the memory cells being at least partly formed by capacitors ($C_p$) on the sidewalls of the trenches (12) surrounding the pairs of memory cells.

2. A device according to claim 1, wherein the parts ($C_p$) of the data charge capacitor (15) of one of the memory cells of each memory cell pair which is formed on the sidewalls of the associated trench are separated from parts ($C_p$) of the data charge storage capacitor (15) of the other memory cell of the memory cell pair by an isolation oxide film (2').

3. A device according to claim 1 or 2, wherein the channel (11) of the transistor of each memory cell is separated from the data charge storage capacitor (15) thereof by an isolation oxide film between the channel and said trench in a direction parallel to the word lines (7a—7d).

4. A device according to claim 1, 2 or 3, wherein the or each isolation film (2', 2) is above an impurity diffusion layer (14).

5. A device according to any one of claims 1 to 4, wherein each part ($C_p$) of the data charge storage capacitor (15) formed on a sidewall of one of the trenches (12) comprises a first electrode formed by a heavily diffused region (5) on the sidewall, an insulating film (4) as a dielectric on the first electrode, and a second electrode formed by a polysilicon layer (3) on the insulating film (4).

6. A device according to any one of claims 1 to 5, wherein the memory cells of the memory cell pairs in one of the memory cell pair lines (L1, L2) are connected to alternate bit lines (6a, 6c) and the memory cell pairs in adjacent memory cell pair lines are connected to the other interleaving bit lines (6b, 6d).

7. A device according to any one of claims 1 to 6, wherein the bit lines (6a, 6b) connected to the memory cells (MC11, MC12, MC21, MC22) in a memory cell pair line (L1) pass over said trenches (12) separating adjacent memory cell pairs in an adjacent memory cell line (L2).

8. A device according to any one of claims 1 to 6, wherein the memory cell pairs in one of the memory cell pair lines (L1, L2) are offset with respect to the memory cell pairs in another memory cell pair line (L2, L1) adjacent to said one of the memory cell pair lines, by half an interval between the successive memory cell pairs in the same cell pair line, so that said trenches (12) separating memory cell pairs in the same cell pair line are in alignment with the bit line connected to the memory cell pair in the adjacent cell pair line.

9. A device according to any one of claims 1 to 8 wherein the trenches (12) which separate the adjacent memory cell pairs in the same memory cell pair line (L1, L2) extend in the direction of the bit lines (6a—6d).

10, A device according to any one of the claim 1 to 9, wherein the trenches (12) which separate the adjacent memory cell lines from one another extend in the direction of the word lines (7a—7d).

11. A device according to any one of claims 1 to 10, wherein the isolation oxide film (2, 2') electrically isolates electrodes of the data charge storage capacitors (15) of the pair of memory cells sharing a contact hole.

12. A device according to any one of claims 1 to 11, wherein the data charge storage capacitor (15) of one of the memory cells of each memory cell pair is separated from the data charge storage capacitor (15) of the other memory cell of the memory cell pair also by an impurity diffused layer (14) formed on the bottom of the sidewalls of said trenches (12).

13. A device according to any one of claims 1 to 12, wherein the channel of the transistor of each memory cell is separated from the data charge storage capacitor also by an impurity diffused layer (14) formed on a flat part of the substrate between the channel and the isolation trench and beneath the isolation film (2).

**Patentansprüche**

1. Halbleiterspeichervorrichtung, bestehend aus einem Feld von Speicherzellen in einer Faltbitleitungskonfiguration, welche Vorrichtung aufweist;

ein Halbleitersubstrat (1);

Speicherzellen (MC11—MC24), die zur Ausbildung einer Matrix in Reihen und Spalten angeordnet sind, wobei jede Speicherzelle einen Datenladungsspeicherkondensator (15) und ein Übertragungsgate umfaßt, das in Form eines Transistors auf dem Substrat vorliegt mit Source- und Drainbereichen, einem Kanal (11), Isolationsoxidfilmen (2, 2') auf beiden Seiten des Kanals (11), Wortleitungen (7a—7d), die sich in einer ersten Richtung parallel zueinander erstrecken, um über die Kanäle (11) der Transistoren hinwegzugehen, Bitleitungen (6a—6d), die an die Source/Drainbereiche der Transistoren angeschlossen sind, wobei sich die Bitleitungen parallel zueinander und in einer Richtung senkrecht zur ersten Richtung erstrecken, wobei alle zwei benachbarten Bitleitungen ein gefaltetes Bitleitungspaar bilden; in welcher benachbarte Speicherzellen in Paaren mit sich einen gemeinsamen Kontakt (10) zum Anschluß an eine jeweilige Bitleitung teilenden Zellen jedes Paares angeordnet sind, in welcher die Speicherzellen in zu den Wortleitungen parallelen Zeilen angeordnet sind, wobei die Transistoren erster Speicherzellen der jeweiligen Speicherzellenpaare in einer Speicherzellenpaarzeile (L1, L2) mit ihren Kanälen (11) unter einer Wortleitung (7a, 7c) liegend vorgesehen sind, um so durch diese gesteuert zu werden, und die Transistoren zweiter Speicherzellen der jeweiligen Speicherzellenpaare in derselben Speicherzellenpaarzeile mit ihren Kanälen (11) unter einer anderen an diese eine Wortleitung angrenzenden Wortleitung (7b, 7d) liegend vorgesehen sind, um durch diese gesteuert zu werden, und in welcher die benachbarten Speicherzellenpaarzeilen und die in derselben Speicherzellenpaarzeile zueinander benachbarten Speicherzellenpaare durch Gräben (12) mit einer Isolationsschicht auf dem Boden jedes Grabens getrennt sind, so daß jedes Speicherzellenpaar von einem Isolationsgraben umgeben ist, und in welcher die Datenladungsspeicherkondensatoren (15) der Speicherzellen zumindest teilweise von Kondensatoren (C$_p$) auf den Seitenwänden der die Speicherzellenpaare umgebenden Gräben (12) gebildet sind.

2. Vorrichtung nach Anspruch 1, in welcher die Teile (C$_p$) des Datenspeicherkondensators (15) einer der Speicherzellen jedes Speicherzellenpaares, der auf den Seitenwänden des zugeordneten Grabens ausgebildet ist, von Teilen (C$_p$) des Datenspeicherkondensators (15) der anderen Speicherzelle des Speicherzellenpaares durch einen Isolationsoxidfilm (2') getrennt sind.

3. Vorrichtung nach Anspruch 1 oder 2, in welcher der Kanal (11) des Transistors jeder Speicherzelle von deren Datenladungsspeicherkondensator (15) durch einen Isolationsoxidfilm zwischen dem Kanal und diesem Graben in einer Richtung parallel zu den Wortleitungen (7a—7d) getrennt ist.

4. Vorrichtung nach Anspruch 1, 2 oder 3, in welcher der oder jeder Isolationsfilm (2, 2') oberhalb einer Fremddatomeindiffundierungsschicht (14) liegt.

5. Vorrichtung nach einem der Ansprüche 1 bis 4, in welcher jeder auf einer Seitenwand eines der Gräben (12) ausgebildete Teil (C$_p$) des Datenladungsspeicherkondensators (15) eine durch einen stark diffundierten Bereich (5) auf der Seitenwandung ausgebildete erste Elektrode, einen Isolationsfilm (4) als Dielektrikum auf der ersten Elektrode und eine zweite durch eine Polyziliziumschicht (3) auf dem Isolationsfilm (4) ausgebildete Elektrode umfaßt.

6. Vorrichtung nach einem der Ansprüche 1 bis 5, in welcher die Speicherzellen der Speicherzellenpaare in einer der Speicherzellenpaarzeilen (L1, L2) an alternierende Bitleitungen (6a, 6c) angeschlossen sind und die Speicherzellenpaare in benachbarten Speicherzellenpaarzeilen an die anderen dazwischen verschränkten Bitleitungen (6b, 6d) angeschlossen sind.

7. Vorrichtung nach einem der Ansprüche 1 bis 6, in welchem die an die Speicherzellen (MC11, MC12, MC21, MC22) in einer Speicherzellenpaarzeile (L1) angeschlossenen Bitleitungen (6a, 6b) über die benachbarte Speicherzellenpaare in einer benachbarten Speicherzellenzeile (L2) trennenden Gräben (12) herübergehen.

8. Vorrichtung nach einem der Ansprüche 1 bis 6, in welcher die Speicherzellenpaare in einer der Speicherzellenpaarzeilen (L1, L2) bezüglich der Speicherzellenpaare in einer anderen zu dieser einen der Speicherzellenpaarzeilen benachbarten Speicherzellenpaarzeile (L2, L1) um das halbe Intervall zwischen aufeinanderfolgenden Speicherzellenpaaren in derselben Zellenpaarzeile versetzt sind, so daß die Speicherzellenpaare in derselben Zellenpaarzeile trennenden Gräben (12) bezüglich der an das Speicherzellenpaar in der benachbarten Zellenpaarzeile angeschlossenen Bitleitung ausgerichtet sind.

9. Vorrichtung nach einem der Ansprüche 1 bis 8, in welcher die Gräben (12), die die benachbarten Speicherzellenpaare in derselben Speicherzellenpaarzeile (L1, L2) trennen, sich in der Richtung der Bitleitungen (6a—6d) erstrecken.

10. Vorrichtung nach einem der Ansprüche 1 bis 9, in welcher die Gräben (12), die die benachbarten Speicherzellenzeilen voneinander trennen, sich in Richtung der Wortleitungen (7a—7d) erstrecken.

11. Vorrichtung nach einem der Ansprüche 1 bis 10, in welcher der Isolationsoxidfilm (2, 2') die Elektroden der Datenladungsspeicherkondensatoren (15) des Paares sich ein Kontaktloch teilender Speicherzellen elektrisch isoliert.

12. Vorrichtung nach einem der Ansprüche 1 bis 11, in welcher der Datenladungsspeicherkondensator (15) einer der Speicherzellen jedes Speicherzellenpaars vom Datenladungsspeicherkondensator (15) der anderen Speicherzelle des Speicherzellenpaares ebenfalls durch eine Fremddatomeindiffundierungsschicht (14) getrennt ist, die auf dem Boden der Seitenwände der Gräben (12) ausgebildet ist.

13. Vorrichtung nach einem der Ansprüche 1 bis 12, in welcher der Kanal des Transistors jeder Speicherzelle vom Datenladungsspeicherkondensator ebenfalls durch eine Fremddatomeindiffundierungsschicht (14) getrennt ist, die auf einem flachen Teil des Substrats zwischen dem Kanal und dem Isolationsgraben und unterhalb des Isolationsfilms (2) ausgebildet ist.

**Revendications**

1. Dispositif de mémoire à semi-conducteurs comprenant un réseau de cellules de mémoire disposé selon une configuration de lignes de bits repliée; ledit dispositif comprenant:
un substrat semi-conducteur (1);
des cellules de mémoire (MC11—MC24) agencées en rangées et en colonnes pour former une matrice, chacune des cellules de mémoire comprenant un condensateur (15) de stockage des charges de données et une porte de transfert, la porte de transfert prenant la forme d'un transistor sur le substrat ayant des régions de source et de drain, un canal (11), des films d'oxyde isolant (2, 2') des deux côtés du canal (11), des lignes de mots (7a—7d) orientées parallèlement entre elles dans une première direction pour passer au-dessus des canaux (11) des transistors, des lignes de bits (6a—6d) reliées aux régions sources/ drains des transistors, les lignes de bits étant parallèles entre elles dans une seconde direction perpendiculaire à la première direction et chaque groupe de deux lignes de bits adjacentes constituant une paire de lignes de bits repliée; dans lequel les cellules de mémoire adjacentes sont agencées par paires, les cellules de chaque paire se partageant un contact commun (10) qui assure la connexion avec une ligne de bits correspondante, les cellules de mémoire étant agencées en lignes parallèles aux lignes de mots, les transistors des premières cellules de mémoire des paires respectives des cellules de mémoires sur une ligne (L1, L2) des paires de cellules de mémoire ayant leurs canaux (11) disposés sous une ligne de mots (7a—7c) afin d'être commandés par cette ligne et les transistors des secondes cellules de mémoire des paires respectives des cellules de mémoire de la même ligne de paires de cellules de mémoire ayant leurs canaux (11) placés sous l'autre ligne de mots (7b—7d) adjacente à ladite première ligne de mots, pour être commandés par cette ligne, et dans lequel les lignes adjacentes des paires de cellules de mémoire et les paires de cellules de mémoire adjacentes entre elles sur la même ligne de paires de cellules de mémoire sont séparées par des rainures (12) avec une couche d'isolant au fond de chaque rainure, si bien que chaque paire de cellules de mémoire est entourée par une rainure d'isolement, les condensateurs (15) de stockage des charges des données des cellules de mémoire étant au moins partiellement constituées par des condensateurs (C$_p$) sur les parois latérales des rainures (12) entourant les paires des cellules de mémoire.

2. Dispositif selon la revendication 1, dans lequel les parties (C$_p$) du condensateur (15) des charges de données de l'une des cellules de mémoire de chaque paire de cellule de mémoire qui sont formées sur les parois latérales de la rainure associée sont séparées des parties (C$_p$) du condensateur (15) de stockage des charges de mémoire de l'autre cellule de mémoire de la paire des cellules de mémoire par un film (2') d'oxyde isolant.

3. Dispositif selon l'une des revendications 1 ou 2, dans lequel le canal (11) du transistor de chaque cellule de mémoire est séparé du condensateur (15) de stockage des données correspondant par un film d'oxyde isolant placé entre le canal et ladite rainure dans une direction parallèle aux lignes de mots 7a—7d.

4. Dispositif selon l'une des revendications 1, 2 ou 3 dans lequel le ou chaque film isolant (2', 2) se trouve au-dessus d'une couche 14 à diffusion d'impuretés.

5. Dispositif selon l'une quelconque des revendications 1 à 4, dans lequel chaque partie (C$_p$) du condensateur (15) de stockage des charges de données formée sur une paroi latérale de l'une des rainures (12) comporte une première électrode formée par une région (5) fortement diffusée sur la paroi latérale, un film isolant (4) servant de diélectrique sur la première électrode, et une seconde électrode formée par une couche de polysilicium (3) sur le film isolant (4).

6. Dispositif selon l'une quelconque des revendications 1 à 5, dans lequel les cellules de mémoire des paires de cellules de mémoire de l'une des lignes (L1, L2) des paires de cellules de mémoire sont reliées à une sur deux des lignes de bits (6a, 6c) et les paires des cellules de mémoire des lignes adjacentes des paires de cellules de mémoire sont reliées aux autres lignes de bits intercalées (6b, 6d).

7. Dispositif selon l'une quelconque des revendications 1 à 6, dans lequel les lignes de bits (6a, 6b) connectées aux cellules de mémoire (MC11, MC12, MC21, MC22) sur une ligne (L1) des paires de cellules de mémoire passent au-dessus desdites rainures (12) séparant des paires de cellules de mémoire adjacentes sur une ligne (L2) de cellules de mémoire adjacentes.

8. Dispositif selon l'une quelconque des revendications 1 à 6, dans lequel les paires de cellules de mémoire de l'une des lignes (L1, L2) des paires de cellules de mémoire sont décalées par rapport aux paires des cellules de mémoire d'une autre ligne (L2, L1) des paires de cellules de mémoire adjacentes à ladite première des lignes des paires de cellules de mémoire, d'un demi-intervalle entre les paires successives des cellules de mémoire de la même ligne de paires de cellules, afin que lesdites rainures (12) séparant des paires de cellules de mémoire sur la même ligne de paires de cellules soient alignées avec la ligne de bits connectée à la paire des cellules de mémoire de la ligne adjacente des paires de cellules.

9. Dispositif selon l'une quelconque des revendications 1 à 8 dans lequel les rainures (12) qui séparent les paires de cellules de mémoire adjacentes sur la même ligne (L1, L2) des paires de cellules de mémoire s'étend dans la direction des lignes de bits (6a, 6d).

10. Dispositif selon l'une quelconque des revendications 1 à 9, dans lequel les rainures (12) qui séparent l'une de l'autre les lignes adjacentes de cellules de mémoire s'étendent dans la direction des lignes de mots (7a—7d).

11. Dispositif selon l'une quelconque des revendications 1 à 10, dans lequel le film d'oxyde isolant (2, 2') isole diélectriquement les électrodes des condensateurs (15) de stockage des charges de données de la paire des cellules de mémoire se partageant un orifice de contact.

12. Dispositif selon l'une quelconque des revendications 1 à 11, dans lequel le condensateur (15) de stockage des charges de données de l'une des cellules de mémoire de chaque paire de cellules de mémoire est isolé du condensateur (15) de stockage des charges de données de l'autre cellule de mémoire de la paire des cellules de mémoire également par une couche (14) à diffusion d'impuretés formée sur le bas des parois latérales desdites rainures (12).

13. Dispositif selon l'une quelconque des revendications 1 à 12, dans lequel le canal du transistor de chaque cellule de mémoire est séparé du condensateur de stockage des charges de données également par une couche (14) à diffusion d'impuretés formée sur une partie plane du substrat entre le canal et la rainure d'isolement et au-dessous du film d'isolement (2).

# FIG.1A

# FIG.1B

# F I G . 2

# FIG.3

EP 0 237 361 B1

# F I G . 4

# FIG.5

# FIG.6